# EUROPEAN PATENT APPLICATION

(11) **EP 3 696 924 A1**
(43) Date of publication of application: **19.08.2020**
(21) Application number: 19220043.4
(22) Date of filing: 30.12.2019
(51) Int. Cl.: H01S 3/23, H01S 3/00, H01S 3/067

(54) **OPTICAL AMPLIFICATION APPARATUS AND LIGHT IRRADIATION APPARATUS**

(30) Priority: 29.01.2019 JP 2019013339
(71) Applicant: CANON KABUSHIKI KAISHA, Ohta-ku Tokyo 146-8501 (JP)
(72) Inventor: OTA, Takefumi, Tokyo, 146-8501 (JP)
(74) Representative: WESER & Kollegen Patentanwälte PartmbB

(57) **Abstract**

The present invention provides an optical amplification apparatus (100A-100B, 200A-200D) for amplifying light from a light source (101, 201), comprising: a combiner (102, 202) configured to output light received at a first input port (102a, 202a) from the light source as first light (Li), and output light received at a second input port (102b, 202b) as second light (L₂); an optical amplifier (103, 203) configured to amplify an intensity of each of the first light and the second light output from the combiner; a splitter (105, 205) configured to output the received first light from a first output port (105b, 205b), and output the received second light from a second output port (105c, 205c); and an optical modulator (106, 206) configured to attenuate an intensity of light output from the first output port of the splitter, wherein the light output from the first output port of the splitter is received at the second input port of the combiner via the optical modulator.

## Description

### BACKGROUND OF THE INVENTION

### Field of the Invention

The present invention relates to an optical amplification apparatus and a light irradiation apparatus.

### Description of the Related Art

In order to obtain a high-power laser output, a technique is used in which an output from a seed light source having a relatively low output and high stability is increased using an external amplifier based on the principle of stimulated emission. This technique is called MOPA (Master Oscillator Power Amplifier).

MOPA can be used to amplify a short-pulse laser output of a mode-locked laser or the like. For example, in a short pulse laser, in order to continuously stably oscillate a laser beam of several picoseconds (ps) or less in a resonator, a state (energy, pulse duration, and spectrum) of a pulse beam in the resonator is limited to a certain range, so that it is difficult to increase the direct output from the resonator. In particular, in a fiber laser using an optical fiber, the output from a resonator can be limited by a nonlinear effect and a breakdown threshold in the optical fiber. Therefore, in such a case, it is preferable to use the MOPA method. The MOPA method can be used, not only for a short pulse laser, but to amplify CW light (Continuous Wave light) output from a small, inexpensive, and stable semiconductor laser.

In an optical amplifier that amplifies pulsed light, the average power of the pulsed light array that can be amplified is limited. Therefore, in order to increase the pulse energy (light intensity) of one pulsed light component using the optical amplifier, it is preferable that the repetition frequency of the pulsed light array is decreased using an optical modulator such as a pulse picker and then the pulsed light array is input to the optical amplifier. On the other hand, when the repetition frequency of the pulsed light array is decreased, the period between the pulsed light components becomes longer. For this reason, in the pulsed light array output from the optical amplifier, ASE light (Amplified Spontaneous Emission light) generated between the pulsed light components as noise tends to be large.

Japanese Patent Laid-Open No. 2018-45229 proposes a method of propagating a pulsed light array through a spectral filter and an optical amplifier twice using polarization in order to decrease the spectral line width. In the method described in Japanese Patent Laid-Open No. 2018-45229, in order to suppress oscillation due to the extinction ratio and ASE light, the output of excitation light input to the optical amplifier is adjusted in a loop using polarization. However, this method suppresses the amplification factor of the optical amplifier, and is insufficient in terms of the efficiency of optical amplification.

### SUMMARY OF THE INVENTION

The present invention provides, for example, a low-noise and high-efficiency optical amplification apparatus.

The present invention in its first aspect provides an optical amplification apparatus as specified in claims 1 to 10.

The present invention in its second aspect provides a light irradiation apparatus as specified in claim 11.

Further features of the present invention will become apparent from the following description of exemplary embodiments with reference to the attached drawings.

### BRIEF DESCRIPTION OF THE DRAWINGS

Fig. 1 is a view showing an arrangement example of an optical amplification apparatus according to the first embodiment;
Fig. 2 is a view showing the arrangement of the optical amplification apparatus in Example 1;
Fig. 3 is a view showing an arrangement example of an optical amplification apparatus according to the second embodiment;
Fig. 4 is a view showing the arrangement of the optical amplification apparatus in Example 2;
Fig. 5 is a view showing the arrangement of an optical amplification apparatus in each of Examples 3 and 4;
Fig. 6 is a view showing the arrangement of an optical amplification apparatus in Example 5;
Fig. 7 is a view showing an example of a processing apparatus;
Fig. 8 is a view showing an arrangement example of a conventional optical amplification apparatus; and
Fig. 9 is a view showing another arrangement example of the conventional optical amplification apparatus.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

First, the basic principle of an optical amplification apparatus will be described. In an optical amplification apparatus, in order to obtain a high-power laser output, a MOPA technique can be applied in which an output from a seed light source having a relatively low output and high stability is increased using an external amplifier based on the principle of stimulated emission. Here, an example will be described in which a pulsed light array output from the seed light source is amplified using the MOPA technique.

In amplification of pulsed light using the MOPA technique, chirp pulse amplification (CPA) can be performed in which, instead of simply inputting pulsed light, the pulse of the light is expanded in time to decrease the peak value before the pulsed light is amplified. In this case, by performing dispersion compensation for compensating the chirp given first, a pulsed light array having high energy and a short pulse width (that is, high output and short pulse) can be obtained. In addition, in an optical amplifier that amplifies pulsed light, the average power of the amplified pulsed light array is limited. Therefore, in order to increase the pulse energy of one pulsed light component using the optical amplifier, it is preferable to decrease the repetition frequency of the pulsed light array to obtain the same average power. Examples of a method for decreasing the repetition frequency of the pulsed light array include, for example, a method using a pulse picker that thins out the pulsed light components from the pulsed light array at a predetermined period.

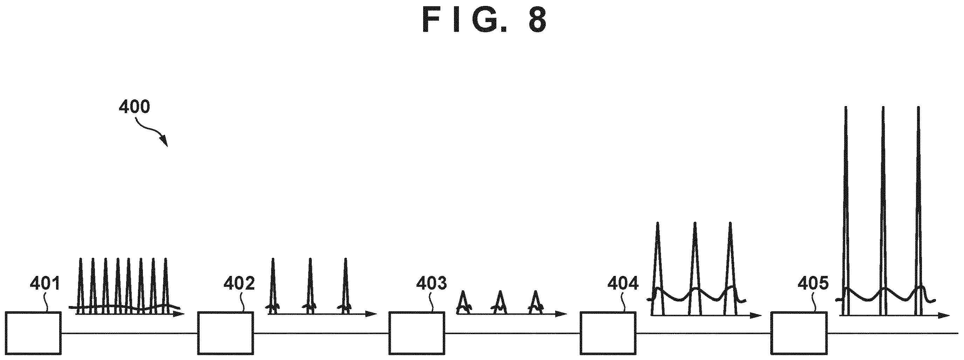

Fig. 8 is a view showing an arrangement example of a conventional optical amplification apparatus 400 that combines the above-described techniques. A pulsed light array output from a seed light source 401 is received by an optical modulator 402 that controls the attenuation of the light intensity of the pulsed light. Here, as the optical modulator 402, for example, a pulse picker that thins out pulsed light components from the pulsed light array at a predetermined period by on/off control (control signal) to decrease the repetition frequency of the pulsed light array can be used. The pulsed light array whose repetition frequency has been decreased by the optical modulator 402 is propagated through a chirping element 403, in which the duration of each pulsed light component is increased and the peak intensity is decreased. The pulsed light array output from the chirping element 403 is input to an optical amplifier 404, and the pulse energy (light intensity) is amplified by the optical amplifier 404. The pulsed light array output from the optical amplifier 404 is input to a dispersion compensator 405. The dispersion compensator 405 performs chirp compensation so that pulse compression occurs in the pulsed light array. As a result, the pulsed light array having high energy and a short pulse width (that is, high output and short pulse) can be obtained. Note that the chirping element 403 and dispersion compensator 405 may not be provided depending on the intensity of the pulsed light array from the seed light source 401 or the optical amplification method.

As described above, in the method of amplifying the pulse energy by the optical amplifier 404 after the optical modulator 402 decreases the repetition frequency of the pulsed light array, ASE light (Amplified Spontaneous Emission light) generated due to noise components between pulsed light components amplified by the optical amplifier 404 tends to be large. As one method for reducing the ASE light, there is a method of decreasing the amplification factor of the optical amplifier 404, but this method can be insufficient to efficiently amplify the light (pulsed light array) from the seed light source 401. Therefore, in each of the following embodiments, an optical amplification apparatus that can efficiently amplify light from the seed light source 401 while reducing ASE light as noise will be described.

### <First Embodiment

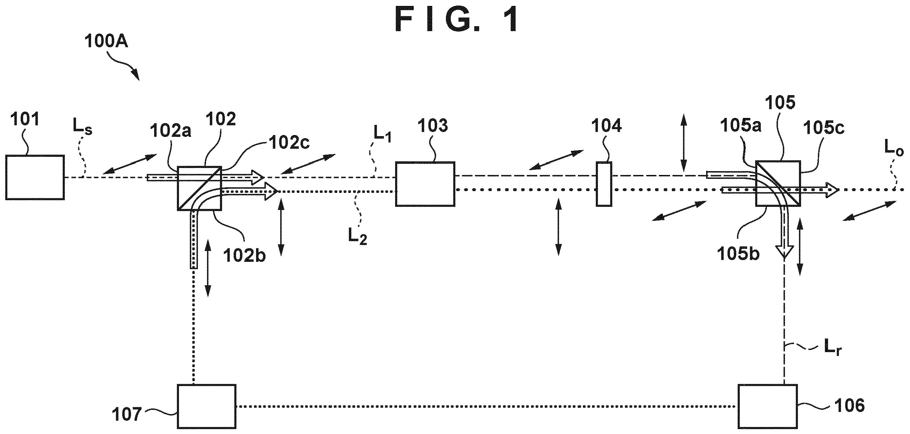

An optical amplification apparatus according to the first embodiment of the present invention will be described. In this embodiment, an arrangement example of an optical amplification apparatus that does not include a chirping element and a dispersion compensator will be described. Fig. 1 is a view showing an arrangement example of an optical amplification apparatus 100A of this embodiment. The optical amplification apparatus 100A of this embodiment can include, for example, a polarization combiner 102, an optical amplifier 103, a polarization controller 104, a polarization splitter 105, and an optical modulator 106. In Fig. 1, the polarization state of light at each location in the optical path is represented by an arrow.

Seed light Ls having linearly polarized light (horizontal polarized light) is output from a seed light source 101, and the seed light Ls is incident on a first input port 102a (first input terminal) of the polarization combiner 102 as horizontal polarized light. The light received at the first input port 102a of the polarization combiner 102 as the horizontal polarized light is output from an output port 102c (output terminal) of the polarization combiner 102 as first light L1 of horizontal polarized light. Here, in the example shown in Fig. 1, the seed light Ls of horizontal polarized light is incident on the first input port 102a of the polarization combiner 102, but the seed light Ls of vertical polarized light may be incident on the first input port 102a. In addition, the polarization combiner 102 shown in Fig. 1 is configured to output the light, which has been input to the first input port 102a or a second input port 102b, from the output port 102c without changing the polarization state, but the polarization combiner 102 may be configured to change the polarization state of the input light and output it from the output port 102c.

The first light L1 output as horizontal polarized light from the output port 102c of the polarization combiner 102 is input to the optical amplifier 103. The optical amplifier 103 has a function of increasing the intensity of input light to be larger than 1 assuming that the intensity of the input light is 1, so that it amplifies the first light L1 output from the output port 102c of the polarization combiner 102. The first light L1 whose intensity has been amplified by the optical amplifier 103 is incident on the polarization controller 104.

The polarization controller 104 includes, for example, a half-wavelength plate and has a function of changing (rotating 90°) the polarization state. In the example shown in Fig. 1, the first light L1 input to the polarization controller 104 is output with the polarization state changed from horizontal polarized light to vertical polarized light. Here, when the polarization combiner 102 is configured to change the polarization state of the input light and output it, the polarization controller 104 may not be provided. In addition, the polarization controller 104 may be arranged on the optical path of light Lr output from a first output port 105b of the polarization splitter 105 and input to the second input port 102b of the polarization combiner 102.

The first light L1 output as vertical polarized light from the polarization controller 104 is input to an input port 105a (input terminal) of the polarization splitter 105. The first light L1 input as vertical polarized light to the input port 105a of the polarization splitter 105 is output as vertical polarized light Lr from the first output port 105b (first output terminal) of the polarization splitter 105. Here, the polarization splitter 105 shown in Fig. 1 is configured to output the light input to the input port 105a from the first output port 105b or a second output port 105c without changing the polarization state. However, the polarization splitter 105 may be configured to change the polarization state of the input light and output it from one of the output ports 105b and 105c. Further, the polarization splitter 105 may use the member (component) similar to that of the polarization combiner 102 and be arranged in a direction different from that of the polarization combiner 102 in the optical path.

The light Lr output as vertical polarized light from the first output port 105b of the polarization splitter 105 is input to the optical modulator 106. The optical modulator 106 has no optical amplification effect, but has a function of decreasing, in accordance with a control signal, the intensity of input light to be 1 or less assuming that the intensity of the input light is 1, so that is attenuates the intensity of the light Lr output from the first output port 105b of the polarization splitter 105 in accordance with the control signal. In this embodiment, for example, when a pulsed light array is used as the seed light Ls, a pulse picker that thins out pulsed light components from the pulsed light array at a predetermined period by on/off control to decrease the repetition frequency of the pulsed light array can be used as the optical modulator 106.

The light Lr output from the optical modulator 106 is input as vertical polarized light to the second input port 102b (second input terminal) of the polarization combiner 102 via a light-guiding optical system 107 including a mirror or the like. The light input as vertical polarized light to the second input port 102b of the polarization combiner 102 is output from the output port 102c of the polarization combiner 102 as second light L2 having a polarization state different from that of the first light L1, that is, as vertical polarized light. The second light L2 output as vertical polarized light from the output port 102c of the polarization combiner 102 is amplified by the optical amplification 103, has its polarization state changed from vertical polarized light to horizontal polarized light by the polarization controller 104, and is incident on the input port 105a of the polarization splitter 105. The second light L2 input as horizontal light to the input port 105a of the polarization splitter 105 is output (emitted) as horizontal polarized light Lo from the second output port 105c (second output terminal) of the polarization splitter 105.

As described above, in the optical amplification apparatus 100A of this embodiment, by using the polarization combiner 102 and the polarization splitter 105, one optical amplifier 103 performs optical amplification a plurality of times. With this arrangement, the number of relatively expensive components such as the optical amplifier 103 can be reduced, which is advantageous in regards to cost reduction. Further, in such an arrangement, since optical amplification is performed in a plurality of steps, the ASE light generated in the first optical amplification by the optical amplifier 103 is reduced (cut) by the optical modulator 106, so that noise reduction can be implemented.

Further, the polarization combiner 102 and the polarization splitter 105 may output light (that is, leakage light) in a polarization state that should not be output due to the extinction ratio. In this case, leakage light is repeatedly propagated through the optical amplifier 103, and laser oscillation can occur depending on the optical amplification factor of the optical amplifier 103. In the optical amplification apparatus 100A of this embodiment, leakage light is reduced (cut) by the optical modulator 106 and optical amplification is performed in a plurality of steps, so that laser oscillation due to the leakage light can be suppressed.

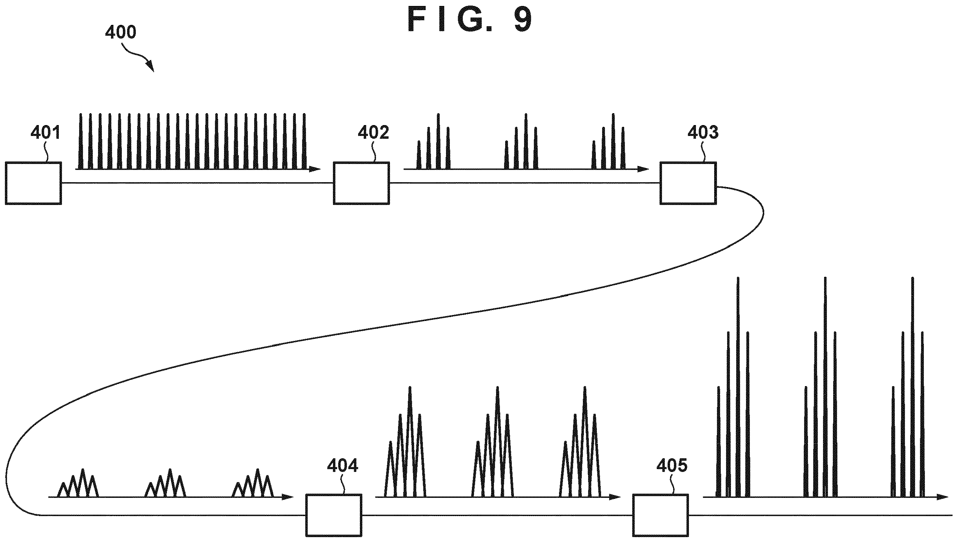

Here, in this embodiment, a pulse picker that thins out pulsed light components from a pulsed light array at a predetermined period by on/off control is used as the optical modulator 106. On the other hand, as a laser processing apparatus using an optical amplification apparatus, there is an apparatus called a burst mode that intermittently outputs a pulsed light group consisting of several pulsed light components. In this case, as shown in Fig. 9, the optical modulator 106 may be configured to attenuate the light intensity for each pulsed light group. Even in this case, the ASE light is attenuated, and noise can be reduced.

### [Example 1]

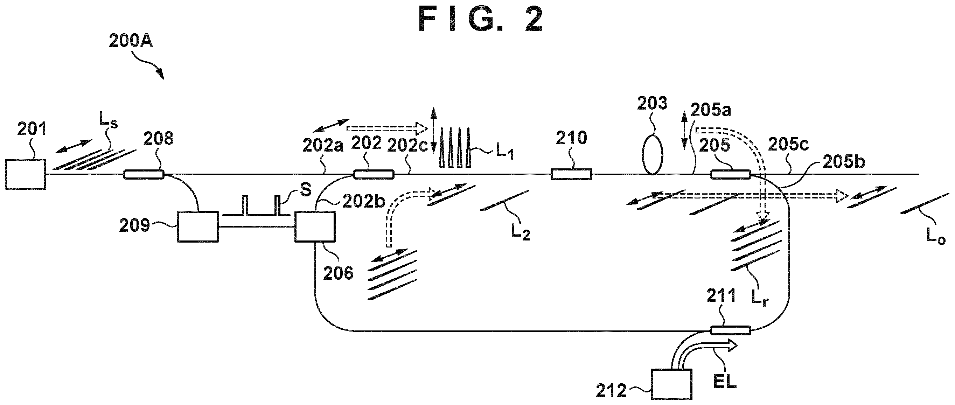

An example of the optical amplification apparatus according to this embodiment will be described with reference to Fig. 2. Fig. 2 is a view showing the arrangement of an optical amplification apparatus 200A in Example 1.

A seed pulsed light source 201 outputs the seed pulsed light Ls (pulsed light array) that maintains the polarization and is propagated along the first polarization axis (Slow axis) of the polarization maintaining optical fiber. In this example, a short pulse fiber laser formed by a polarization maintaining optical fiber is used as the seed pulsed light source 201. The seed pulsed light Ls output from the seed pulsed light source 201 has, for example, a wavelength of 1,040 nm, a repetition frequency of 50 MHz, an average output of 5 mW (pulse energy of 100 pJ), and a pulse duration of 800 fs.

The seed pulsed light Ls is branched by an optical brancher 208, part (for example, 10%) of which is input to a synchronizer 209 (synchronization circuit) and the rest of which is input to a first input port 202a of a polarization combiner 202. The synchronizer 209 observes the pulsed light array of the seed pulsed light Ls and generates, based on the repetition frequency of the observed pulsed light array, an electrical signal S for controlling a pulse picker 206 serving as an optical modulator. The synchronizer 209 uses the electrical signal S to control the pulse picker 206 so as to synchronize with the phase of the seed pulsed light Ls (that is, the phase of the light input to the first input port 202a of the polarization combiner 202). That is, the synchronizer 209 controls the pulse picker 206 so as to synchronize with the phase of the seed pulsed light Ls so that the intensity of the light Lr output from a first output port 205b of a polarization splitter 205 is periodically attenuated.

As the polarization combiner 202, for example, a fiber polarization beam combiner is used. When light along the first polarization axis (Slow axis) of the polarization maintaining optical fiber is input to the first input port 202a (port 1), the polarization combiner 202 outputs light (first light L1) along the second polarization axis (Fast axis) of the polarization maintaining optical fiber from an output port 202c (port 3). That is, the seed pulsed light Ls output from the seed pulsed light source 201 as light propagated along the first polarization axis is output, from the output port 202c (port 3), as light propagated in a polarization state along the second polarization axis.

The first light L1 (pulsed light array) output from the polarization combiner 202 is propagated through an optical isolator 210 and then an optical amplifier 203, by which the light intensity is amplified. In this example, the optical amplifier 203 is formed by, for example, a gain fiber having a gain material added thereto, and an YbDF (Yb (ytterbium) Doped Fiber) having a length of 1 m can be used as the gain fiber. The first light L1 whose light intensity has been amplified by the optical amplifier 203 is input to an input port 205a (port 3) of the polarization splitter 205.

As the polarization splitter 205, for example, a fiber polarization beam splitter having the same arrangement as the polarization combiner 202 is used. When the first light L1 along the second polarization axis is input to the input port 205a (port 3), the polarization splitter 205 outputs the light Lr along the first polarization axis from the first output port 205b (port 1). That is, when the amplified pulsed light array propagated along the second polarization axis is input to the input port 205a, the polarization splitter 205 outputs, from the first output port 205b, the pulsed light array (light Lr) propagated along the first polarization axis.

The light Lr (pulsed light array) output from the first output port 205b of the polarization splitter 205 is propagated through a fiber coupler 211 for guiding excitation light EL that excites the gain fiber of the optical amplifier 203. The fiber coupler 211 is, for example, a WDM (Wavelength Division Multiplexing) fiber coupler. The excitation light EL is light output from an excitation light source 212 and has a wavelength of 975 nm, for example. The fiber coupler 211 has polarization characteristics and has a large loss with respect to light propagated along the second polarization axis. Therefore, it is preferable to insert the fiber coupler 211 not between the output port 202c of the polarization combiner 202 and the input port 205a of the polarization splitter 205, but between the first output port 205b of the polarization splitter 205 and a second input port 202b of the polarization combiner 202.

The light Lr (pulsed light array) propagated through the fiber coupler 211 is input to the pulse picker 206 serving as an optical modulator. As described above, the pulse picker 206 synchronizes with the phase of the seed pulsed light Ls based on the electrical signal S supplied from the synchronizer 209, thereby periodically attenuating the intensity of the light Lr output from the first output port 205b of the polarization splitter 205. More specifically, the pulse picker 206 performs processing of thinning out the pulsed light components from the pulsed light array of the light Lr at a predetermined period by on/off control. As a result, the pulsed light array having the repetition frequency decreased is generated.

Here, the electrical signal S supplied from the synchronizer 209 is, for example, a signal for performing pulse picking at 100 kHz in synchronization with the pulsed optical array. As the pulse picker 206, for example, a modulator based on the principle of AOM (Acousto-Optic Modulation) can be used. However, the present invention is not limited to this, and a modulator based on another principle such as EOM (Electro-Optic Modulation) may be used as the pulse picker 206.

The light (pulsed light array) whose repetition frequency has been decreased by the pulse picker 206 is input to the second input port 202b (port 2) of the polarization combiner 202 as light along the first polarization. When the light along the first polarization axis is input to the second input port 202b (port 2), the polarization combiner 202 outputs, from the output port 202c (port 3), light (second light L2) along the first polarization axis. The second light L2 (the pulsed light array whose repetition frequency has been decreased) output from the output port 202c of the polarization combiner 202 is propagated through the optical isolator 210 and then the optical amplifier 203 again, by which the light intensity is amplified. The light which is propagated through the optical amplifier 203 in the first step is the light (first light L1) in the polarization state along the second polarization axis, but the light which is propagated in the second step is the light (second light L2) in the polarization state along the first polarization axis.

The second light L2 whose light intensity has been amplified by the optical amplifier 203 is input to the input port 205a (port 3) of the polarization splitter 205. When the second light L2 along the first polarization axis is input to the input port 205a (port 3), the polarization splitter 205 outputs, from the second output port 205c (port 2), the light Lo along the first polarization axis. According to the measurement result, the output light Lo (pulsed light array) output from the second output port 205c of the polarization splitter 205 had an average output of 1 mW (pulse energy of 10 µJ).

As described above, the optical amplification apparatus 200A in this example can perform optical amplification a plurality of times with one optical amplifier 203 by using the polarization combiner 202 and the polarization splitter 205. Therefore, the number of relatively expensive components such as the optical amplifier 203 (gain fiber) and the excitation light source 212 is reduced, which is advantageous in cost reduction. Further, in such an arrangement, since the optical amplification is performed in a plurality of steps, the ASE light and leakage light generated in the first optical amplification are reduced by the pulse picker 206 (optical modulator), so that reduction of ASE light and suppression of unintended laser oscillation can be implemented. Furthermore, since the optical amplification is performed after the repetition frequency of the pulsed light array is decreased, stimulated emission is efficiently performed in the optical amplifier 203, so that reduction of ASE light and suppression of unintended laser oscillation can be implemented.

Here, in this example, the optical brancher 208 is inserted immediately after the output port of the seed pulsed light source 201. However, in order to improve the light detection accuracy in the synchronizer 209, it may be desirable to increase the light intensity guided to the synchronizer 209. In this case, an optical amplifier may be added between the seed pulsed light source 201 and the optical brancher 208. Alternatively, the optical brancher 208 may be arranged in the optical path from the optical amplifier 203 to the pulse picker 206.

In this example, in order to reduce light (for example, ASE light or the like) that is propagated backward from the first input port 202a of the polarization combiner 202 serving as an input port of light to the optical amplification apparatus 200A, the optical isolator 210 is inserted between the polarization combiner 202 and the optical amplifier 203. However, the optical isolator 210 may not be inserted when there is a small possibility that a component failure or oscillation due to the backward propagation light (return light) will occur. In addition, the optical isolator 210 is not limited to be inserted between the polarization combiner 202 and the optical amplifier 203, and may be inserted at an arbitrary location on the optical path as long as it does not block the light (including the excitation light EL) propagated in the direction in which the light should be propagated through the apparatus.

In this example, the exciting method in the optical amplifier 203 (gain fiber) is backward excitation in which the excitation light EL is propagated in the direction opposite to the propagation direction of the pulsed light to be amplified. However, the present invention is not limited to this, and forward excitation in which the excitation light EL is propagated in the same direction as the pulsed light to be amplified may be used.

In this example, the example in which the optical amplification apparatus 200A is formed by a fiber element has been described. However, the present invention is not limited to this, and the optical amplification apparatus 200A may be configured spatially. For example, as each of the polarization combiner 202 and the polarization splitter 205, instead of the fiber polarization beam combiner/splitter, a polarization beam combiner/splitter made of parallel flat glass or a prism may be used. Such a polarization beam combiner/splitter can be configured, for example, to transmit one of horizontal polarized light and vertical polarized light and reflect the other in the direction of 90° with respect to the optical axis of the incident light. By using the polarization beam combiner/splitter, the beam diameter can be increased, and damage to the optical fiber element due to the energy of the beam can be avoided. When such a polarization beam combiner/splitter is used, a wavelength controller that changes the polarization state can be inserted between the polarization combiner 202 and the polarization splitter 205 as in the arrangement example shown in Fig. 1. For example, a polarizer, half-wave plate, or quarter-wave plate can be used as the wavelength controller.

For example, assume that a polarization beam combiner/splitter that transmits horizontal polarized light and reflects vertical polarized light is used. In this case, the light incident on the first input port 202a of the polarization combiner 202 as the horizontal polarized light passes through the polarization combiner 202, is converted into the vertical polarized light by the half-wave plate, and then is incident on the polarization splitter 205. The vertical polarized light incident on the input port 205a of the polarization splitter 205 is reflected by the polarization splitter 205 and output from the first output port 202b, and then is incident on the second input port 202b of the polarization combiner 202 while remaining as vertical polarized light. The light incident on the second input port 202b of the polarization combiner 202 as vertical polarized light is reflected and output by the polarization combiner 202, is converted into horizontal polarized light by the half-wave plate, is incident on the polarization splitter 205, passes through the polarization splitter 205, and is output from the second output port 202c.

The optical amplifier 203 is not limited to a gain fiber. It can be a gain medium as long as optical amplification with respect to the wavelength of the seed pulsed light is performed, and may be a semiconductor amplifier or a bulk gain material. In this case, the fiber coupler 211 may not be provided because the gain medium may be excited by electric power or optical coupling of space.

### <Second Embodiment

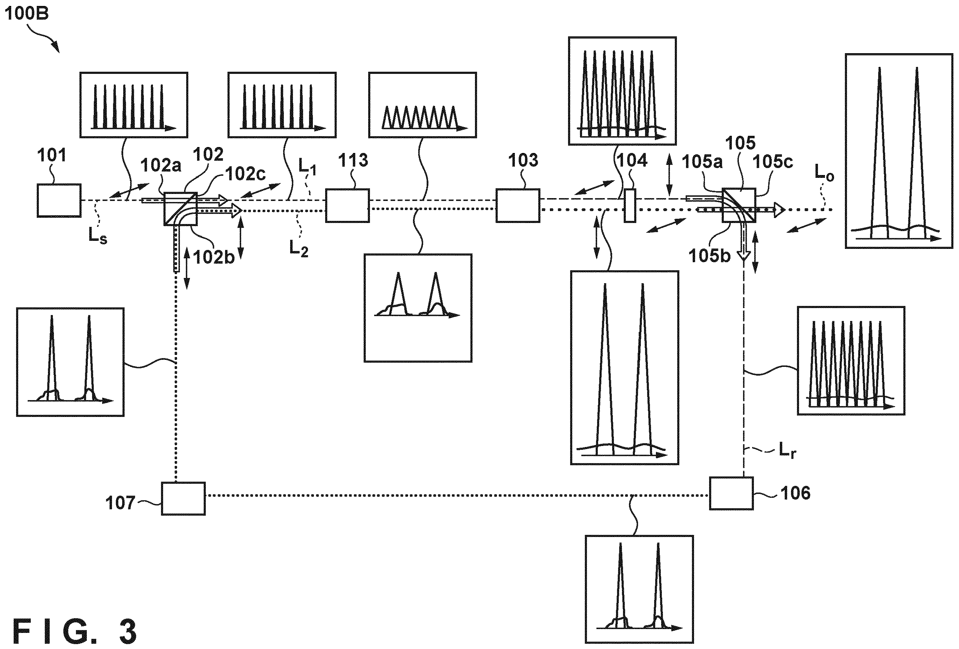

An optical amplification apparatus according to the second embodiment of the present invention will be described. Fig. 3 is a view showing an arrangement example of an optical amplification apparatus 100B of this embodiment, and also shows the state of a pulsed light array at each location in the optical path of the optical amplification apparatus 100B. The optical amplification apparatus 100B of this embodiment basically takes over the optical amplification apparatus 100A of the first embodiment, but is different therefrom in that a chirping element 113 is provided between a polarization combiner 102 and an optical amplifier 103. The chirping element 113 is an element for increasing the duration of each pulsed light component in the pulsed light array by delaying the phase of the light in accordance with the wavelength of the light. In each pulsed light component propagated through the chirping element 113, the duration is increased and the peak intensity is decreased as shown in Fig. 3.

In the optical amplification apparatus 100B of this embodiment, by using the polarization combiner 102 and a polarization splitter 105, the single chirping element 113 and the single optical amplifier 103 allow a plurality of times of chirping and a plurality of times of optical amplification. With this arrangement, it is possible to shorten the fiber length of the optical amplifier 103 necessary for optical amplification of chirped pulsed light and to reduce the number of relatively expensive components such as the optical amplifier 103 (gain fiber) and excitation light source, which is advantageous in cost reduction. Further, in such an arrangement, since optical amplification is performed in a plurality of steps, the ASE light and leakage light generated in the first optical amplification are reduced (cut) by an optical modulator 106, so that reduction of ASE light and suppression of unintended laser oscillation can be implemented. Furthermore, since the optical amplification is performed after the repetition frequency of the pulsed light array is decreased, stimulated emission is efficiently performed in the optical amplifier 103, so that reduction of ASE light and suppression of unintended laser oscillation can be implemented.

Here, in the optical amplifier 103, the efficiency of stimulated emission can be changed (that is, the optical amplification factor can be changed) depending on the intensity of the light to be amplified. The optical amplification apparatus 100B of this embodiment performs chirping and optical amplification in a plurality of steps. That is, the processing of performing optical amplification after decreasing the peak intensity of the pulsed light is performed in two steps. Therefore, stimulated emission can be generated with high efficiency near the peak of the pulsed light, and as a result, ASE light can be reduced.

### [Example 2]

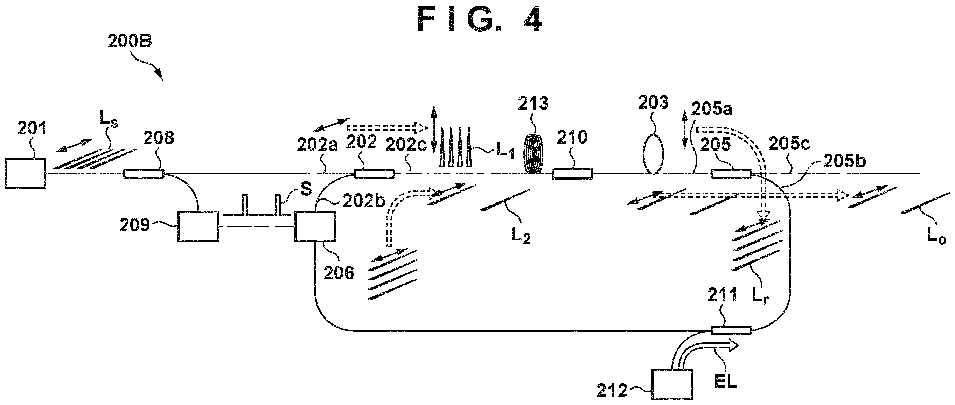

An example of the optical amplification apparatus according to this embodiment will be described with reference to Fig. 4. Fig. 4 is a view showing the arrangement of an optical amplification apparatus 200B in Example 2. The optical amplification apparatus 200B in this example basically takes over the optical amplification apparatus 200A in Example 1 shown in Fig. 2, but a chirping element 213 is further provided between a polarization combiner 202 and an optical amplifier 203 (an optical isolator 210).

First light L1 (pulsed light array) output from the polarization combiner 202 is input to the chirping element 213 and the phase of the first light L1 is changed for each wavelength by the chirping element 213 so that the duration of each pulsed light component is increased. In this example, a long polarization maintaining optical fiber having a length of 200 m is used as the chirping element 213 and has an amount of wavelength dispersion of 0.1 ps/nm or more. It is preferable to use the polarization maintaining fiber which has normal dispersion with respect to light having a wavelength of 1,040 nm and performs single mode propagation.

As described in Example 1, the first light L1 output from the chirping element 213 is propagated through the optical isolator 210 and then the optical amplifier 203, by which the light intensity is amplified. The first light L1 whose light intensity has been amplified by the optical amplifier 203 is input to an input port 205a of a polarization splitter 205 and output from a first output port 205b as light Lr (pulsed light array). The light Lr output from the polarization splitter 205 is propagated through a fiber coupler 211, and has its repetition frequency decreased by a pulse picker 206 serving as an optical modulator. Thereafter, the light Lr is input to a second input port 202b of the polarization combiner 202 and output as second light L2 (pulsed light array).

The second light L2 output from the polarization combiner 202 is propagated again through the chirping element 213, the optical isolator 210, and the optical amplifier 203, and then is input to the polarization splitter 205 and output from a second output port 205c as output light Lo. The light which is propagated through the chirping element 213 and the optical amplifier 203 in the first step is the light (first light L1) in the polarization state along the second polarization axis, but the light which is propagated in the second step is the light (second light L2) in the polarization state along the first polarization axis.

Here, in this example, in order to reduce light (for example, ASE light or the like) that is propagated backward from a first input port 202a of the polarization combiner 202 serving as an input port of light to the optical amplification apparatus 200B, the optical isolator 210 is inserted between the chirping element 213 and the optical amplifier 203. However, the optical isolator 210 may not be inserted when there is a small possibility that a component failure or oscillation due to the backward propagation light (return light) will occur. In addition, the optical isolator 210 is not limited to be inserted between the chirping element 213 and the optical amplifier 203, and may be inserted at an arbitrary location on the optical path as long as it does not block the light (including the excitation light EL) propagated in the direction in which the light should be propagated through the apparatus.

In this example, the optical amplification apparatus 200B is formed by a fiber element, and chirping by the chirping element 213 is performed in two steps. Therefore, as compared with a conventional optical amplification apparatus, the fiber length of the chirping element 213 necessary for implementing the same chirp amount as the conventional apparatus may be half, which is advantageous in cost reduction. On the other hand, the chirping element 213 is formed by an optical fiber in this example, but the present invention is not limited to this, and the chirping element 213 may be formed using, for example, a dispersion element such as a prism or a diffraction grating. In this case, the optical path length in space or the like can be decreased and control of the dispersion value can be easily controlled, so that higher-order dispersion can be controlled and final pulse compression can be easily performed. Further, in this example, a normal dispersion chirp is applied to the pulsed light. However, if a phenomenon in which the pulsed light is temporally compressed by the Sorington effect or the like due to the nonlinear effect does not occur, an anomalous dispersion chirp may be applied to the pulsed light.

### <Third Embodiment>

An optical amplification apparatus according to the third embodiment of the present invention will be described. The optical amplification apparatus of this embodiment basically takes over the optical amplification apparatus of each of the first and second embodiments, but is different therefrom in that an optical delay element is provided. The optical delay element is used to shift the phase of the first light L1 and the phase of the second light L2 output from the polarization combiner 102 from each other. That is, the optical delay element is an element for adjusting the pulsed light component in the first light L1 and the pulsed light component in the second light L2 so as not to overlap in time. When two pulsed light arrays having different polarization states are propagated on the same optical axis, cross-phase modulation as a nonlinear effect may occur and the spectral shapes and time shapes may be changed. In this embodiment, such a nonlinear effect can be avoided by providing the optical delay element.

### [Example 3]

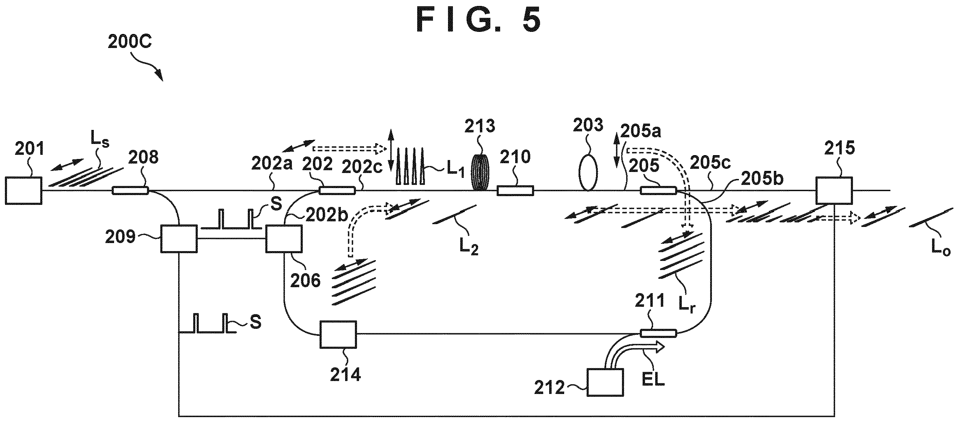

An example of the optical amplification apparatus according this embodiment will be described with reference to Fig. 5. Fig. 5 is a view showing the arrangement of an optical amplification apparatus 200C in Example 3 (note that the arrangement shown in Fig. 5 also includes the arrangement in Example 4 to be described later). The optical amplification apparatus in this example basically takes over the optical amplification apparatus 200B in Example 2 shown in Fig. 4, but an optical delay element 214 is further provided. In this example, a polarization maintaining optical fiber having a length of 1 m can be used as the optical delay element 214. Here, in the arrangement example shown in Fig. 5, the optical delay element 214 is arranged on the optical path of light output from a polarization splitter 205 and input to a polarization combiner 202, but the present invention is not limited to this, and the optical delay element 214 may be arranged at an arbitrary location. Further, as the optical delay element 214, the length of the polarization maintaining optical fiber used as a chirping element 213 may be adjusted.

### <Fourth Embodiment>

An optical amplification apparatus according to the fourth embodiment of the present invention will be described. The optical amplification apparatus of this embodiment basically takes over the optical amplification apparatus of each of the first to third embodiments, but is different therefrom in that a second modulator is further provided. The second modulator is used to attenuate the intensity of the light Lo output from the second output port 105c of the polarization splitter 105.

Ideally, the polarization splitter 105 is configured to output the whole first light L1 input to the input port 105a as the light Lr from the first output port 105b. However, in practice, part of the first light L1 input to the input port 105a is output from the second output port 105c together with the output light Lo. The ratio at which the light to be output from the second output port 105c in this manner is extinguished is called an "extinction ratio", and it is difficult to achieve an extinction ratio of 100%. Therefore, in this embodiment, there is provided a second optical modulator that periodically attenuates the intensity of light output from the second output port 105c of the polarization splitter 105 using a control signal synchronized with the repetition frequency of the pulsed light in the seed light (pulsed light array). With this arrangement, it is possible to reduce (cut) the leakage light of the first light L1 out of the light output from the second output port 105c of the polarization splitter 105, thereby obtaining the output light of the second light L2 having undergone optical amplification twice.

### [Example 4]

An example of the optical amplification apparatus according to this embodiment will be described with reference to Fig. 5. The optical amplification apparatus in this example basically takes over the optical amplification apparatus in Example 3, but a second pulse picker 215 is further provided as the second optical modulator. The second pulse picker 215 synchronizes with the phase of seed pulsed light Ls based on an electrical signal S supplied from a synchronizer 209, thereby performing processing of attenuating light at a predetermined period by on/off control with respect to the light Lo output from a second output port 205c of a polarization splitter 205. As a result, the leakage light of the first light L1 out of the light output from the second output port 205c of the polarization splitter 205 is reduced (cut), so that the output light of the second light L2 is obtained. This can implement further noise reduction by further reducing the ASE light.

### <Fifth Embodiment>

An optical amplification apparatus according to the fifth embodiment of the present invention will be described. The optical amplification apparatus of this embodiment basically takes over the optical amplification apparatus of each of the first to fourth embodiments, but is different therefrom in that an optical amplification synchronizer (synchronization circuit) is further provided. The optical amplification synchronizer causes the optical amplifier 103 to amplify the light intensity in synchronization with the input timing of light to the optical amplifier 103. That is, the optical amplification synchronizer controls the gain of the optical amplifier 103 so that the input timing of the pulsed light to the optical amplifier 103 and the amplification timing of the pulsed light by the optical amplifier 103 are synchronized. With this arrangement, since the amplification by the optical amplifier 103 with respect to the noise components between the pulsed light components is limited, it is possible to implement further noise reduction by further reducing the ASE light.

### [Example 5]

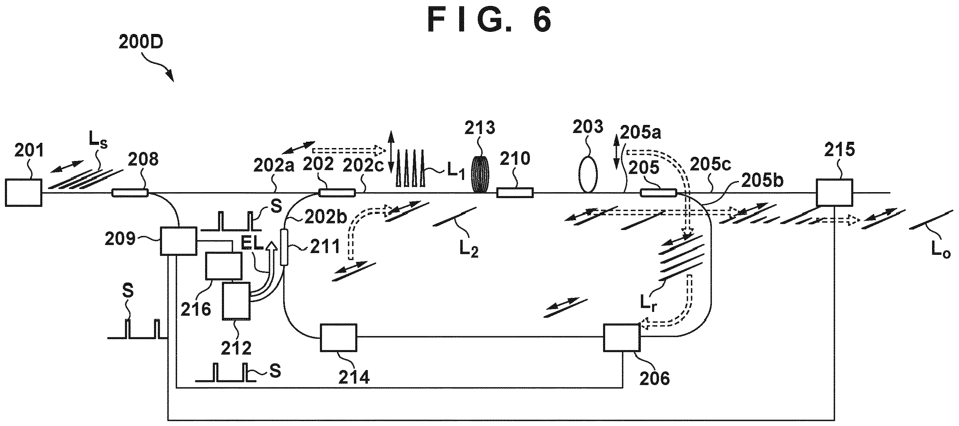

An example of the optical amplification apparatus according to this embodiment will be described with reference to Fig. 6. Fig. 6 is a view showing the arrangement of an optical amplification apparatus 200D in Example 5. The optical amplification apparatus in this example basically takes over the optical amplification apparatus 200C shown in Fig. 5, but an optical amplification synchronizer 216 is further provided.

In this example, a fiber coupler 211 and an excitation light source 212 for guiding excitation light EL that excites the gain fiber of an optical amplifier 203 can be configured to perform forward excitation in which the excitation light EL is propagated in the same direction as the pulsed light to be amplified. In addition, the optical amplification synchronizer 216 switches emission/non-emission of the excitation light EL from the excitation light source 212 so as to synchronize the input timing of the pulsed light to the optical amplifier 203 and the amplification timing of the pulsed light by the optical amplifier 203. More specifically, the optical amplification synchronizer 216 controls the excitation light source 212 so as to emit the excitation light EL in synchronization with the phase of seed pulsed light Ls based on an electrical signal S from a synchronizer 209.

For example, the optical amplification synchronizer 216 controls the excitation light source 212 to modulate the intensity of the excitation light EL so as to synchronize the pulsed light array of the seed light Ls having a repetition frequency of 50 MHz and the pulsed light array having the repetition frequency decreased to 100 kHz by a pulse picker 206. Since the repetition frequency of the seed pulse light Ls is 50 MHz, the seed pulse light Ls is input at a period of 20 ns. Therefore, the excitation light EL is turned on for a time width of 5 ns or less so that the pulsed light array of the seed pulsed light Ls and the pulsed light array of 100 kHz are synchronized. Here, when the excitation light source 212 is formed by a semiconductor laser or the like, the lifetime of the light emitting element depends on the light emission time. In this example, since the light emission time can be shortened, the lifetime of the optical amplification apparatus (excitation light source 212) can be extended.

### <Sixth Embodiment>

An embodiment of a light irradiation apparatus using an optical amplification apparatus according to the present invention will be described. The light irradiation apparatus includes, for example, any one of the optical amplification apparatuses of the first to fifth embodiments described above, and irradiates a target object with output light from the optical amplification apparatus to perform processing or observation of the target object. For example, a processing apparatus that processes a target object includes a laser processing machine that guides output light from an optical amplification apparatus to a five-axis laser scanner and irradiates the target object, thereby performing laser processing.

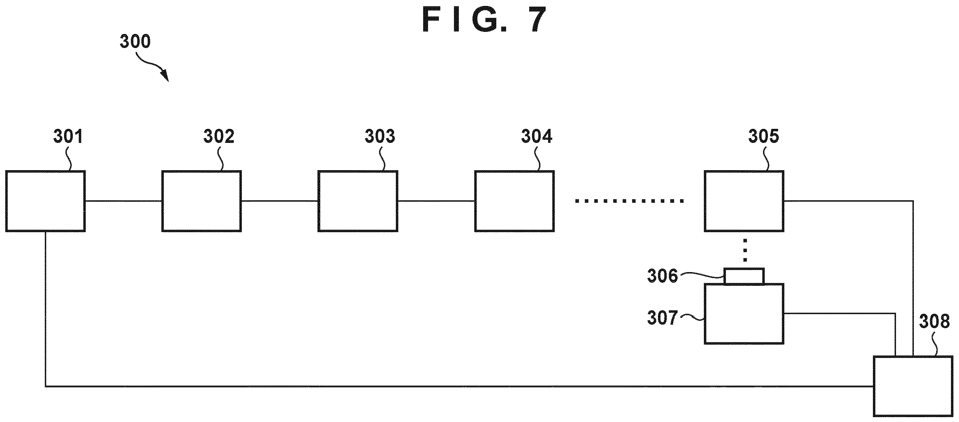

Fig. 7 is a view showing an example of a processing apparatus 300 of this embodiment. Light (pulsed light array) emitted from a seed light source 301 is input to an optical amplification apparatus 302. The optical amplification apparatus 302 can include any one of the optical amplification apparatuses of the first to fifth embodiments described above. The light output from the optical amplification apparatus 302 is input to an external optical amplifier 303 to further amplify the light intensity, and a pulsed light array having a center wavelength of 1,040 nm, an average output of 5 W, and a repetition frequency of 100 kHz is obtained. The light output from the external optical amplifier 303 is input to a chirp compensator 304, and a high-output and short-pulse light having a pulse width of 1 ps is generated by the chirp compensator 304. The light output from the chirp compensator 304 is input to a five-axis laser scanner 305, and a workpiece 306 (target object) is irradiated with the light and scanned by the five-axis laser scanner 305. The workpiece 306 is, for example, an aluminum plate having a thickness of 500 µm. A movable stage 307 holds the workpiece 306 to control its position. The seed light source 301 (output timing of seed light), the five-axis laser scanner 305, and the stage 307 are controlled by a controller 308. The controller 308 can be formed by a computer including, for example, a CPU, a memory, and the like.

Here, the light irradiation apparatus may include an optical wavelength modulator that causes the light output from the optical amplification apparatus to be incident on a nonlinear medium and outputs light having a wavelength different from that of the incident light. More specifically, the optical wavelength modulator uses nonlinear crystal, PPLN, an optical fiber, or the like to generate supercontinuum light with a broad wavelength range, an optical soliton pulse, parametric light, and higher harmonic, thereby outputting light having a wavelength different from that of incident light. Note that PPLN is an abbreviation for Periodically Poled Lithium Niobate.

The light irradiation apparatus may include a mechanism for generating terahertz (THz) light by causing the light output from the optical amplification apparatus to be incident on an optical electric field switch. Further, the light irradiation apparatus may be a nonlinear microscope that inputs the light output from the optical amplification apparatus or the light output from the optical wavelength modulator described above to a laser scanning microscope and observes the nonlinear response of an observation target, thereby identifying a substance without dying it. Furthermore, the light irradiation apparatus may include a mechanism for performing optical coherence tomography using broadband light output from the optical wavelength modulator described above. In this case, a very broad spectrum can be obtained and a high-resolution tomographic image can be acquired. The light irradiation apparatus may include a mechanism for performing optical frequency comb measurement using broadband light output from the optical wavelength modulator described above.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An optical amplification apparatus (100A-100B, 200A-200D) for amplifying light from a light source (101, 201), comprising:
a combiner (102, 202) configured to output light received at a first input port (102a, 202a) from the light source as first light (L₁), and output light received at a second input port (102b, 202b) as second light (L₂) having a polarization state different from a polarization state of the first light;
an optical amplifier (103, 203) configured to amplify an intensity of each of the first light and the second light output from the combiner;
a splitter (105, 205) configured to receive the first light from the optical amplifier and output the first light from a first output port (105b, 205b), and receive the second light from the optical amplifier and output the second light from a second output port (105c, 205c); and
an optical modulator (106, 206) configured to attenuate an intensity of light output from the first output port of the splitter in accordance with a control signal,
wherein the light output from the first output port of the splitter is received at the second input port of the combiner via the optical modulator.

2. The apparatus according to claim 1, further comprising a chirping element (113, 213) configured to delay a phase of light in accordance with a wavelength of light, on an optical path between the combiner and the optical amplifier.

3. The apparatus according to claim 2, wherein the chirping element has an amount of wavelength dispersion of not less than 0.1 ps/nm.

4. The apparatus according to any one of claims 1 to 3, further comprising an optical delay element (214) configured to shift a phase of the first light and a phase of the second light from each other.

5. The apparatus according to any one of claims 1 to 4, further comprising a second optical modulator (215) configured to attenuate an intensity of light output from the second output port of the splitter.

6. The apparatus according to claim 5, wherein the second optical modulator is configured to attenuate the intensity of the light output from the second output port of the splitter so as to synchronize with a phase of the light received at the first input port of the combiner.

7. The apparatus according to any one of claims 1 to 6, further comprising a synchronizer (216) configured to cause the optical amplifier to perform light intensity amplification in synchronization with an input timing of light to the optical amplifier.

8. The apparatus according to any one of claims 1 to 7, further comprising a polarization controller (104) configured to change a polarization state of light, on an optical path of light output from the combiner and received by the splitter.

9. The apparatus according to any one of claims 1 to 8, wherein a pulsed light array output from the light source is received at the first input port of the combiner.

10. The apparatus according to any one of claims 1 to 9, wherein the optical modulator includes a pulse picker.

11. A light irradiation apparatus for irradiating an object with light, comprising:
a light source; and
an optical amplification apparatus defined in any one of claims 1 to 10,
wherein the light irradiation apparatus is configured to irradiate the object with light output from the optical amplification apparatus.
